# EUROPEAN PATENT SPECIFICATION

(11) **EP 3 370 493 B1**
(45) Date of publication and mention of the grant of the patent: **30.11.2022**
(21) Application number: 15907272.7
(22) Date of filing: 29.10.2015
(51) Int. Cl.: G01B 11/00, H05K 13/04, G03F 9/00, G06T 7/73

(54) **BASE PLATE POSITION SEARCHING DEVICE AND COMPONENT MOUNTING MACHINE**
GRUNDPLATTENPOSITIONSSUCHVORRICHTUNG UND KOMPONENTENMONTAGEMASCHINE
DISPOSITIF DE RECHERCHE DE POSITION DE PLAQUE DE BASE ET MACHINE DE MONTAGE DE COMPOSANTS

(43) Date of publication of application: 05.09.2018
(73) Proprietor: Fuji Corporation, Chiryu-shi, Aichi 472-8686 (JP)
(72) Inventor: FUJII Kimio, Chiryu Aichi (JP)
(74) Representative: Grünecker Patent- und Rechtsanwälte PartG mbB
(86) International application number: PCT/JP2015/080534
(87) International publication number: WO 2017/072908

(56) References cited:
- EP-A1- 2 827 131
- JP-A- H0 854 221
- JP-A- H04 340 799
- JP-A- 2002 076 697
- JP-A- 2002 243 412
- JP-A- 2003 317 097
- JP-A- 2012 114 181
- US-A1- 2009 010 525

## Description

### Technical Field

The present invention relates to a board position search device that searches a position of a board that is held in a board production facility or the like and a component mounting machine that is provided with the board position search device.

### Background Art

A solder printing machine, a component mounting machine, a reflow machine, a board inspection machine, and the like may be used as facilities for producing a board on which multiple components are mounted. Typically, the facilities are connected and constitute a board production line. A board production facility other than a reflow machine described above detects a position of a board that is carried in and held, and executes predetermined process work based on the detected position. In the position detection of the board, imaging a position fiducial mark that is attached on the board and searching for the position fiducial mark by executing an image processing on the acquired captured image are typically performed. A technical example which relates to this type of board position detection is disclosed in PTLS 1 and 2.

An electronic component mounting apparatus in PTL 1 performs an image processing using an image processing section by imaging recognition marks (positional fiducial marks) at two locations that are disposed on the circuit board by a recognition camera, and obtains a correction value for correcting the position and rotation of the circuit board. Then, in a case where it is not possible to obtain the correction value, an operator operates a JOG switch while viewing a recognition mark that is displayed on a television monitor, the recognition mark is aligned with the center position of the television monitor, and reads coordinate positions from an NC control section, and thereby the correction value is obtained manually. Thereby, even in a case where it is not possible to obtain the correction value caused by the recognition mark being dirty or broken, inadequate lighting, or the like, it is possible to correct the position and rotation of the circuit board with high precision.

In addition, an electronic component mounting device of PTL 2 is provided with a recognition processing section that ascertains a deviation amount of a position of an electronic component, which is removed from a component supply section by a component suction nozzle, based on a result that is captured by a recognition camera. Then, when a recognition error is generated in the recognition processing section, operation of the electronic component mounting device is paused and a graphic for eye alignment is displayed by activating a component recognition eye alignment mode. Thereby, in a case where even if there is a recognition error the component is not defective, it is possible to mount the component such that it is left to the operator to decide whether to discard or mount.

JP 2002-76697 A discloses a PCB assembly device wherein the position of a mark on a PCB is identified by comparison with an alignment image.

EP2827131A1 relates to an image inspection method and inspection region setting method. An image inspection apparatus is disclosed that uses inspection region defining information including information defining an initial contour of an inspection region and information defining a range based on the initial contour as a search range for searching a contour of the inspection region. The contour of the inspection region is generated by setting a plurality of base points on the initial contour and performing edge search processing on a line that passes through each base point and intersects with the initial contour, within an area of the search range of the inspection target object image, to determine an edge point corresponding to each base point, and by connecting or approximating a plurality of the edge points thus obtained. US 2009/0010525 A1 relates to a method and apparatus for detecting positions of electrode pads. A method for detecting positions of a plurality of electrode pads of semiconductor chips formed on a semiconductor wafer is disclosed that includes setting an imaging target region greater than a semiconductor chip on the semiconductor wafer, performing split imaging so as to entirely cover the imaging target region, and detecting positions of electrode pads of the semiconductor chip by processing images obtained by the split imaging. The split imaging is performed by using an imaging device which enlarges and images a region smaller than the imaging target region by one imaging.

### Citation List

### Patent Literature

PTL 1: JP-A-9-283994
PTL 2: JP-A-2001-308600

### Summary of Invention

### Technical Problem

Note that, recently miniaturization of boards and densification of component mounting have been frequently requested due to the trend toward the board being lighter, thinner, and smaller, and it is desired to save a small space for attaching the position fiducial mark. As a countermeasure, a method is considered in which a dedicated position fiducial mark is not attached on the board, characters such as printed identification codes, component symbols for displaying the types of components as symbols, lands for soldering and the like as a characteristic section which replaces the position fiducial mark. In this case, in the related art technologies exemplified in PTLS 1 and 2, the characteristic section has a predetermined unspecified shape with respect to use of a position fiducial mark that is easy to recognize such as a circle shape or square shape. Therefore, there is a concern that precision for detecting the position of the characteristic section is lowered or automatic detection it is not possible.

In other words, in the related art technology, a mark frame having the same shape as the position fiducial mark is moved to search for a position where the mark frame and position fiducial mark overlap in a captured image acquired by imaging the position fiducial mark of a circle shape, a square shape, or the like. Accordingly, a center position between the position fiducial mark and the mark frame is clear, and position search is comparatively easy if it is assumed that there is breakage or faintness of printing, solder adhesion, and the like on the position fiducial mark. However, the characteristic section such as a character, circuit symbol, or land that is substituted for the position fiducial mark is normally unclear at the center position, and the shape of the external line is complex, therefore the position search tends to be relatively difficult.

The present invention is made in consideration of the problems of the background art, and a problem to be solved is to provide a board position search device and component mounting machine suitable for application to search of a position of a characteristic section with a predetermined shape that is substituted for the position fiducial mark on the board.

### Solution to Problem

A board position search device of the present invention to solve the problem described above is provided with captured image storage means for storing a captured image for which a characteristic section with a predetermined shape that is disposed on a predetermined position on the board is imaged, template storage means for storing a template in which a plurality of simulation points are included that simulate a relative positional relationship of a plurality of feature points of the characteristic section, in-image search means for searching a position of the characteristic section in the captured image, and displaying means for displaying such that the plurality of simulation points of the template are recognized and displaying the template superimposed on the captured image.

In addition, a component mounting machine of the present invention is provided with a board conveyance device that carries in, holds, and carries out a board, the board position search device of the present invention that determines the position of the held board, and a component transfer device that corrects a mounting position of the component based on the position of the determined board when the component that is supplied from a component supply device is mounted on the held substrate.

### Advantageous Effects of Invention

In the board position search device of the present invention, the displaying means displays such that it is possible for an operator to recognize the plurality of simulation points that simulate a relative positional relationship of the plurality of feature points of the characteristic section and displays such that a template that includes the plurality of simulation points superimposed on the captured image in which the characteristic section is captured. Therefore, even if the characteristic section with a predetermined shape that is substituted for the position fiducial mark on the board, the operator is able to easily visually recognize whether or not a degree of overlap between the characteristic section and the template in the captured image is in a good state. In addition, assuming that the shape of the characteristic section changes caused by breakage or faintness of printing, solder adhesion, and the like, the operator is able to recognize a change of shape by visually recognizing the captured image. Accordingly, the board position search device of the present invention is suitable for application to searching of the position of the characteristic section with a predetermined shape on the board.

In addition, according to the component mounting machine of the present invention, production of the board is continued while the position of the board is determined by automatically searching using the in-image search means of the board position search device of the present invention. Then, when it is not possible to automatically search using the in-image search means, the operator adjusts a situation in which the position of the board is searched by a manual operation. Accordingly, production efficiency of the board is comprehensively increased.

It is the object of the present invention to provide an improved circuit board position search device.

This object is solved by the subject matter of the independent claims.

Embodiments are defined by the dependent claims.

### Brief Description of Drawings

[Fig. 1] Fig. 1 is a diagram that schematically illustrates a configuration of a board position search device of a first embodiment along with a board production line and a component mounting machine.
[Fig. 2] Fig. 2 is a diagram of a screen of a display section in which a displaying means displays a template superimposed on a captured image, and exemplifies a screen when a search result of an in-image search means is good.
[Fig. 3] Fig. 3 is a diagram of an operation flow that represents an operation of a board position search device of the first embodiment.
[Fig. 4] Fig. 4 is a diagram of the screen of the display section in which the displaying means displays the template superimposed on the captured image when the search result of the in-image search means is bad.
[Fig. 5] Fig. 5 is a diagram of the screen of the display section that explains a template of a first alternative embodiment of the first embodiment.
[Fig. 6] Fig. 6 is a diagram of the screen of the display section that explains a template of a second alternative embodiment of the first embodiment.
[Fig. 7] Fig. 7 is a diagram of the screen of the display section that explains settings of feature points of a characteristic section and a template shape in the second embodiment.
[Fig. 8] Fig. 8 is a diagram of the screen of the display section that explains settings of feature points of a characteristic section and a template shape in a third embodiment.
[Fig. 9] Fig. 9 is a diagram that schematically indicates a configuration of a board position search device of a fourth embodiment along with a board production line and a component mounting machine of the embodiment.
[Fig. 10] Fig. 10 is a diagram of an operation flow that represents an operation of a board position search device of the fourth embodiment and the component mounting machine of the embodiment.

### Description of Embodiments

### (1. Configuration of Board Production Line 9 and Component Mounting Machine 1)

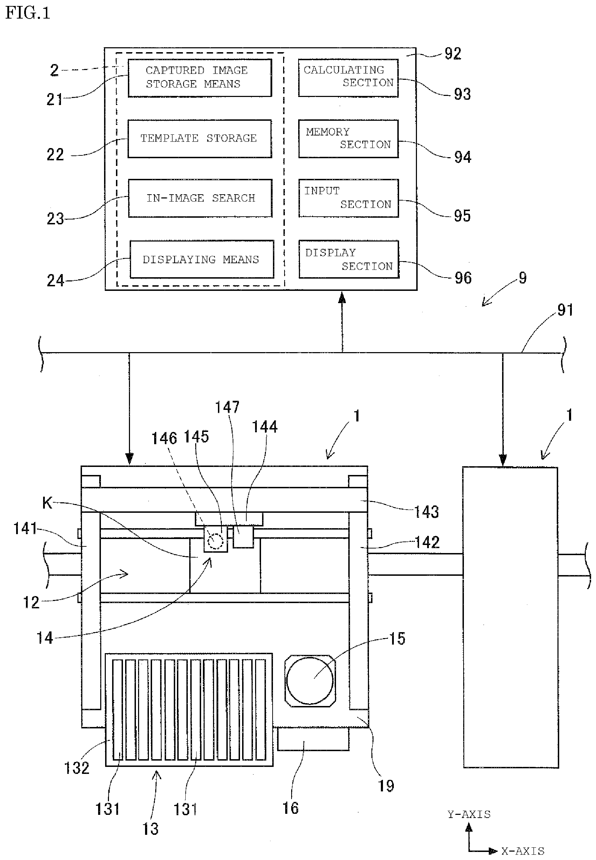

A board position search device 2 of a first embodiment of the present invention will be described with reference to Figs. 1 to 4. The board position search device 2 of the first embodiment is used for application to searching of a position of a board K using a component mounting machine 1 that configures a board production line 9. Fig. 1 is a diagram that schematically indicates a configuration of a board position search device 2 of a first embodiment along with the board production line 9 and the component mounting machine 1. The board production line 9 is configured by multiple sets of board production facilities including the component mounting machine 1, a host computer 92 that is connected to communicate with each set of board production facilities via a network 91, and the like. The board position search device 2 is combined with the host computer 92. Note that, the board position search device 2 is able to capture one functional section of the component mounting machine 1.

The component mounting machine 1 is configured by assembling a board conveyance device 12, a component supply device 13, a component transfer device 14, a component camera 15, a control device 16, and the like on a device table 19. A left-right direction in Fig. 1 is an X-axis direction in which a board conveyance device 12 conveys the board K, and an up-down direction in Fig. 1 is a Y-axis direction. The board conveyance device 12, the component supply device 13, the component transfer device 14, and a component camera 15 are controlled by the control device 16, and respectively carry out predetermined process work. The board position search device 2 is also able to be configured to be combined with the control device 16.

The board conveyance device 12 carries in the board K to a mounting execution position, and holds and carries out the board K. The board conveyance device 12 consists of a pair of guide rails for conveyance, a pair of conveyor belts, a backup device for holding, and the like. The component supply device 13 is configured such that multiple feeder devices 131 are arranged on a pallet table 132 that is detached on an upper face of a device table 19. Each feeder device 131 supplies a component by feeding out a carrier tape from each tape reel.

The component transfer device 14 sucks and collects components from multiple feeder devices 131, and the components are conveyed up to the held board K and mounted. The component transfer device 14 is a device of an XY-robot type that is horizontally movable in the X-axis direction and the Y-axis direction. The component transfer device 14 is constituted by a pair of Y-axis rails 141 and 142 and a Y-axis slider 143 that constitute a head driving mechanism, a mounting head 144 that is driven in the X-axis direction and the Y-axis direction, a nozzle tool 145, a suction nozzle 146, a board camera 147, and the like. The nozzle tool 145 has a suction nozzle 146 that sucks the component and is mounted on the board K while being replaceably held in the mounting head 144. The board camera 147 is provided in the mounting head 144 and images an upper face of the board K.

The component camera 15 is provided with an upward orientation on an upper face of the device table 19 in the vicinity of component supply device 13. The component camera 15 images the state of the components that are sucked by the suction nozzle 146 while the mounting head 144 is moved from the component supply device 13 to on the board K. The control device 16 is assembled on the device table 19 and the installation position of the control device 16 is not particularly limited. The control device 16 is connected to communicate with the host computer 92 or each set of board production facilities on the upstream side and the downstream side via the network 91. The control device 16 controls the component mounting operation according to a mounting sequence that is held advance.

The host computer 92 monitors an operation state of each set of board production facilities including the component mounting machine 1 and controls implementation of a production step. The host computer 92 is a typical computer device, and is provided with a calculating section 93, a memory section 94, an input section 95, a display section 96, and the like. The host computer 92 has a CPU in the calculating section 93 and operates using software. According to need, the host computer 92 receives a command from the operator using the input section 95, displays guide information toward the operator using the display section 96, and refers to data internal to the memory section 94 or an external database.

### (2. Configuration of Board Position Search Device 2 of First Embodiment)

The board position search device 2 of the first embodiment is realized by software of the host computer 92. The software is executed by the operation of the calculating section 93, the memory section 94, the input section 95, and the display section 96. The board position search device 2 is provided with the captured image storage means 21, the template storage means 22, the in-image search means 23, and the displaying means 24.

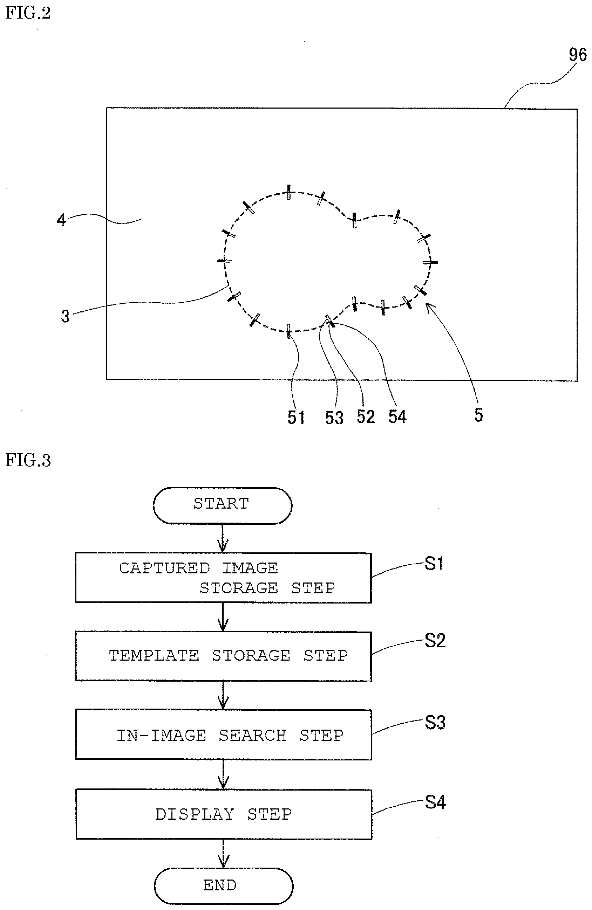

The captured image storage means 21 stores a captured image 4 in which a characteristic section 3 with a predetermined shape is captured. As described below, the captured image storage means 21 captures a range that includes the characteristic section 3 of an upper face of the held board K using a board camera 147 of the component mounting machine 1. Next, the captured image storage means 21 transfers image data of the acquired captured image 4 to the host computer 92 and stores the image data in the memory section 94. Fig. 2 is a diagram of the screen of the display section 96 that displays such that the displaying means 24 superimposes the template 5 on the captured image 4 using the image data of the captured image 4.

The characteristic section 3 is set in advance in order to accurately detect the mounting execution position at which the board K is held. The characteristic section 3 is a character such as an identification code, a component symbol for displaying the type of component as a symbol, a land for soldering and the like printed on the board K, and replaces the position fiducial mark. Preferably the characteristic section 3 is set as two separate locations on the board K, for example, positions close to two corners on a diagonal line. Thereby, the movement and rotation in the X-axis direction and the Y-axis direction of the board K are recognized. The position on the board K of the characteristic section 3 is known and is represented by a coordinate system on the board. The shape of the characteristic section 3 is predetermined, the shape itself is known in advance. However, the actual shape of the characteristic section 3 generates a change of shape caused by breakage or faintness of printing, solder adhesion, and the like. Fig. 2 exemplifies the captured image 4 that represents, with a broken line, the external line of the characteristic section 3 of a gourd shape in which two round shapes are linked.

Multiple feature points that represent the shape of the characteristic section 3 are set discreetly on the external line. The separation distance between each of the feature points may be the same over the entire location, and may each be different locations. In the present first embodiment, the separation distance between each of the feature points is a short distance at a location at which the external line is steeply bent and is a long distance at a location at which the external line is gently bent. Thereby, even with a limited number of feature points, it is possible to represent the shape of the characteristic section 3 with high precision. In addition, since the number of points for searching the degree of overlap is limited in comparison with the related art technology that uses a mark frame which matches the shape of the position fiducial mark, it is possible to carry out the position search in a short time.

The template storage means 22 stores the template 5 that includes multiple simulation points that simulate a relative positional relationship of the multiple feature points of the characteristic section 3. In the example of Fig. 2, the template 5 is made of an aggregate of 17 line segment templates 51 corresponding to 17 feature points. The line segment template 51 that simulates the line segment which intersects at a right angle with the external line through each feature point of the characteristic section 3. Then, each simulation point corresponding to each feature point is a center point 52 of each line segment template 51.

In addition, each line segment template 51 has a different display color on the inside 53 and the outside 54 of the external line at the boundary of the respective center points 52. In Fig. 2, the inside 53 of the line segment template 51 is displayed using a white line and the outside 54 is displayed using a black line. Naturally, in the display section 96 of a color display system, preferably the inside 53 and the outside 54 of the external line of the line segment template 51 are displayed using two colors for ease of understanding.

The template 5 is created as an image of shape data by the host computer 92 or another computer based on the design data of the characteristic section 3 or the captured image obtained by imaging the characteristic section 3 with a good shape under good conditions. The template storage means 22 stores the shape data of the created template 5 is stored in the memory section 94. Note that, a display size of the template 5 is set in advance to match the display size of the characteristic section 3 in the captured image 4, or is automatically adjusted.

The in-image search means 23 searches the position of the characteristic section 3 in the captured image 4. The search is mainly automatically performed using an image processing function of the calculating section 93. The in-image search means 23, for example, relatively moves the template 5 described above in the captured image 4, and obtains the respective distances between each feature point and each center point 52. Then, the in-image search means 23 determines that the template 5 superimposes the characteristic section 3 by the positional relationship in which the total of the distance is the smallest at a predetermined value or less. In this case, it is possible to obtain the position of the characteristic section 3 on the board K based on the relative movement amount of the template 5. Furthermore, it is possible to obtain the position and the rotation of the board K based on the position of the two locations of the characteristic sections 3. In addition, the in-image search means 23 determines a search error in a case where the total of the distance is a predetermined value or less whatever the relative positional relationship.

Note that, the in-image search means 23 may use a template that is different from the template 5 described above, for example, a mark frame of the related art, and may perform a method which is entirely different that does not use the template.

As indicated in Fig. 2, the displaying means 24 displays such that it is possible to recognize the multiple simulation points (center point 52 of each line segment template 51) of the template 5, and displays such that the template 5 superimposes the captured image 4. The displaying means 24 may sequentially display halfway through in which the in-image search means 23 searches the position of the characteristic section 3, and may perform display corresponding to the search result. Furthermore, the implemented content of the position search of the characteristic section 3 that was implemented in the past may be accumulated and entered into a database and the displaying means 24 may display the implemented content of the past.

### (3. Operations and Actions of Board Position Search Device 2 of First Embodiment)

Next, operations and actions of the board position search device 2 of the first embodiment. Fig. 3 is a diagram of an operation flow that represents an operation of the board position search device 2 of the first embodiment. In a captured image storage step S1 in Fig. 3, first, the captured image storage means 21 operates. Thereby, the image data of the captured image 4 that includes the characteristic section 3 in Fig. 2 is stored in the memory section 94. In a subsequent template storage step S2, the template storage means 22 operates. Thereby, shape data of the template 5 that is made of an aggregate of 17 line segment templates 51 in Fig. 2 is stored in the memory section 94. Note that, in the captured image storage step S1 and the template storage step S2, the execution order may be replaced.

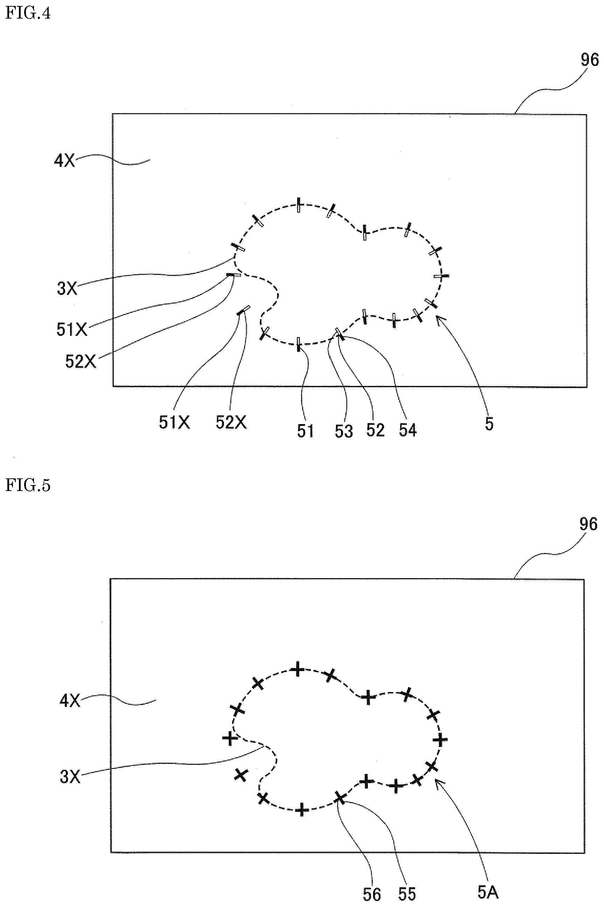

In the subsequent in-image search step S3, the in-image search means 23 operates and automatically searches the position of the characteristic section 3 in the captured image 4. In the subsequent display step S4, the displaying means 24 operates. In this arrangement, the displaying means 24 performs display that corresponds to the search result of the in-image search means 23. In Fig. 2, when the search result is good, a screen is exemplified that is displayed on the display section 96 by the displaying means 24. Meanwhile, Fig. 4 is a diagram of the screen of the display section 96 in which the displaying means 24 superimposes the template 5 on the captured image 4X when the search result of the in-image search means 23 is bad.

In Fig. 2, the center points 52 of all line segment templates 51 roughly superimpose the external line of the characteristic section 3 of the captured image 4. Accordingly, the in-image search means 23 is able to automatically search the position of the characteristic section 3, and is able to determine the actual position of the characteristic section 3 based on the relative movement amount of the template 5. In contrast, in Fig. 4, in the characteristic section 3X of the captured image 4X, a part on the left side in the diagram of the external line is dented and changes shape. As a result of the change of shape, there is considered to be breakage or faintness of printing, solder adhesion, and the like of the characteristic section 3, and furthermore, illumination is bad during capture by the board camera 147 and the like. As a result, the center point 52X of two line segment templates 51X is greatly removed from the external line of the characteristic section 3X of the captured image 4X. Therefore, the in-image search means 23 generates a search error without automatically searching the position of the characteristic section 3X.

The display content of the displaying means 24, that is, the screen that is exemplified in Figs. 2 and 4 is recognized, thereby the operator is able to easily visually recognize whether or not a degree of overlap between the characteristic sections 3, 3X of the captured images 4, 4X and the template 5 is in a good state. In other words, the operator is able to easily recognize whether the search precision is good or bad in the in-image search means 23. In addition, the operator visually recognizes the display content of the displaying means 24, and thereby is able to easily recognize the state during search error generation, the cause therefor, and the like.

Note that, the displaying means 21 may change the display color of two colors of the line segment templates 51 according to the positional relationship of the feature points of the captured images 4, 4X in a case where the template 5 is relatively moved with respect to the characteristic sections 3, 3X of the captured images 4, 4X. For example, when the center point 52 of the line segment templates 51 is superimposed on a predetermined error with respect to the feature point, only green color may be displayed without displaying the line segment templates 51 using two colors. In addition, for example, in a case where the center point 52 of the line segment template 51 is positioned inside the external line of the characteristic sections 3, 3X and a case of being positioned on the outside, the two colors that are used which are different from each other may be combined. In this manner, visual recognition by the operator is further improved by varying the display color of the line segment template 51.

### (4. Aspects and Effects of Board Position Search Device 2 of First Embodiment)

The board position search device 2 of the first embodiment is provided with the captured image storage means 21 that stores the captured image 4, 4X for which characteristic section 3 with a predetermined shape that is disposed on a predetermined position on the board K is imaged, the template storage means 22 that stores the template 5 in which multiple simulation points (center points 52) are included that simulate the relative positional relationship of multiple feature points of the characteristic section 3, the in-image search means 23 that searches the position of the characteristic sections 3, 3X in the captured images 4, 4X, and the displaying means 24 that displays such that the multiple simulation points (center points 52) of the template 5 are recognized and displays the template 5 superimposed on the captured image 4.

In the first embodiment, even if the characteristic section 3 is a predetermined shape that is substituted for the position fiducial mark on the board K, the operator is able to easily visually recognize whether or not a degree of overlap between the characteristic sections 3, 3X of the captured images 4, 4X and the template 5 is in a good state. In addition, assuming that the shape of the characteristic section 3X changes caused by breakage or faintness of printing, solder adhesion, and the like, the operator is able to recognize a change of shape by visually recognizing the captured images 4, 4X. Accordingly, the board position search device 2 of the first embodiment is suitable for application to searching of the position of the characteristic section 3 with a predetermined shape on the board K.

Furthermore, multiple feature points are positioned discreetly on the external line of the characteristic section 3. Thereby, even with a limited number of feature points, it is possible to represent the shape of the characteristic section 3 with high precision. In addition, the number of points of search for the degree of overlap is limited in comparison with the related art technology that uses a mark frame that matches the shape of the position fiducial mark. Accordingly, in a case where the in-image search means 23 searches the position of the characteristic section 3 automatically using the template 5, the required time for searching is reduced. In addition, in a case where the operator manually searches the position of the characteristic section 3 using the template 5, it is easy to determine the degree of overlap.

Furthermore, the template 5 is made of an aggregate of the line segment template 51 that simulates the line segment that intersects at a right angle with the external line through each feature point of the characteristic section 3, and the multiple simulation points of the template 5 are center points 52 of each of the line segment templates 51. Thereby, since the simulation point that does not have an area or length is displayed to be easily viewed using the center points 52 of the line segment templates 51, visual recognition of the operator is favorable.

Furthermore, each line segment template 51 has a different display color on the inside 53 and the outside 54 of the external line at the boundary of the respective center points 52. Thereby, it is easy to understand whether the center points 52 of the line segment templates 51 are positioned inside the external line of the characteristic sections 3, 3X of the captured images 4, 4X or positioned outside, and the center points 52 are reliably visually recognized. Accordingly, the operator is able to easily recognize with good precision the degree of overlap of the characteristic sections 3, 3X and the template 5.

Furthermore, the displaying means 21 may change the display color of the line segment templates 51 according to the positional relationship of the feature points of the captured images 4, 4X in a case where the template 5 is relatively moved with respect to the characteristic sections 3, 3X of the captured images 4, 4X. In this aspect, visual recognition by the operator is further improved.

### (5. Alternative embodiments of Board Position Search Device 2 of First Embodiment)

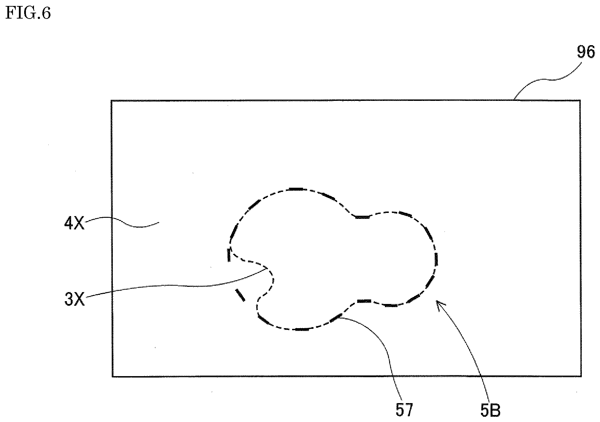

The template 5 in the board position search device 2 of the first embodiment is able to be modified and will be described in detail below. Fig. 5 is a diagram of the screen of the display section 96 that explains a template 5A of a first alternative embodiment of the first embodiment, and Fig. 6 is a diagram of the screen of the display section 96 that explains a template 5B of a second alternative embodiment of the first embodiment.

In the first alternative embodiment in Fig. 5, each line segment template 55 of the template 5A has a symbol 56 that represents respective center points. As exemplified in Fig. 5, it is possible to use an intersection line that is orthogonal to a line segment template 55 as symbol 56. Not limited thereto, a black circle may be used as the symbol 56.

In the first alternative embodiment of the first embodiment, each line segment template 55 of the template 5A has the symbol 56 that represents respective center points. Even in the first alternative embodiment, visual recognition by the operator is favorable in the same manner as for the line segment templates 51 that are displayed using two colors.

In the second alternative embodiment in Fig. 6, a template 5B is made of an aggregate of the tangent template 57 that simulates a tangent that contacts the external line through each feature point of the characteristic section 3, and the multiple simulation points of the template 5B are contact points of each of the tangent templates 57. Even in the second alternative embodiment, visual recognition by the operator is favorable in the same manner as for the line segment templates 51 that are displayed using two colors.

Furthermore, the template may be made of an aggregate of a symbol template that symbolizes each feature point of the characteristic section 3 as the respective simulation points. Whether a circle, x mark, an arrow, or the like that symbolize each feature point is used as the symbol template, the effect of visual recognition by the operator being favorable is the same.

### (6. Board Position Search Device of Second Embodiment)

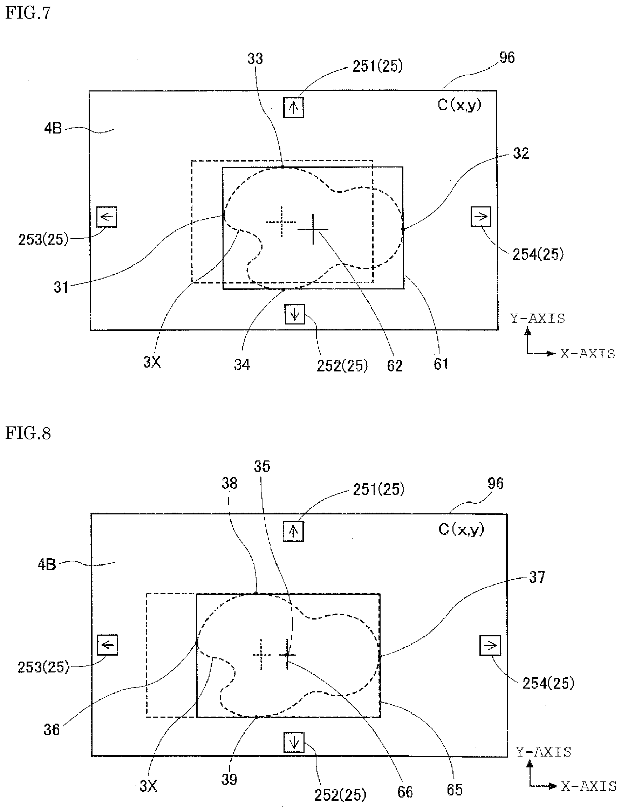

Next, concerning the board position search device of the second embodiment, the points that are different from the first embodiment and alternative embodiments thereof will be mainly explained. In the second embodiment, the configuration of the board production line 9 and the component mounting machine 1 are the same in the first embodiment, and settings of multiple feature points of the characteristic section 3, and the shape of the template are different from the first embodiment. Fig. 7 is a diagram of the screen of the display section 96 that explains settings of feature points of a characteristic section 3 and a template shape in the second embodiment.

In the second embodiment, the multiple feature points of the characteristic section 3 are set as a total of four points. That is, two feature points 31, 32 of a first set that is most separated in the X-axis direction (first direction) out of the points on the external line of the characteristic section 3 and two feature points 33, 34 of a second set that is most separated in the Y-axis direction (second direction) are set.

Meanwhile, the template is a rectangular template 61 in which a rectangular shape is simulated that is disposed parallel to the X-axis direction and the Y-axis direction through the two feature points 31, 32 of the first set and the two feature points 33, 34 of the second set. Each side of the rectangular template 61 is equivalent to simulation points that are to superimpose each of the four feature points 31 to 34. The rectangular template 61 includes a center template 62 with a cross shape that represents a rectangular shape center position. Coordinate values C (x, y) in the captured image 4X of the center template 62 are displayed at all times at the top right of the screen.

Furthermore, the board position search device of the second embodiment is provided with manual operation means 25. An upward movement cursor 251, a downward movement cursor 252, a left movement cursor 253, and a right movement cursor 254 that are displayed on the screen are exemplified as the manual operation means 25. The operator is able to relatively move the rectangular template 61 with respect to the characteristic section 3X in the captured image by clicking a pointer of a mouse of the input section 95 to superimpose any of the movement cursors 251 to 254.

In Fig. 7, the search result of the in- image search means 23 fails, and the rectangular template 61 is displayed at a position that is indicated by an initially broken line. The operator is able to move the rectangular template 61 to a position that is indicated by a solid line by using the downward movement cursor 252 and the right movement cursor 254. In the rectangular template 61 of the position that is indicated by a solid line, each side is superimposed on the respective feature points 31 to 34. At this time, the operator is able to calculate the position of the characteristic section 3 based on the coordinate values C (x, y) of the center template 62.

In the board position search device of the second embodiment, the multiple feature points of the characteristic section 3 have a total of four points of two feature points 31, 32 of a first set that is most separated in the X-axis direction (first direction) out of the points on the external line of the characteristic section 3 and two feature points 33, 34 of a second set that is most separated in the Y-axis direction (second direction) are set, and the template is a rectangular template 61 in which a rectangular shape is simulated that is disposed parallel to the X-axis direction and the Y-axis direction through the two feature points 31, 32 of the first set and the two feature points 33, 34 of the second set, and the multiple simulation points of the template are each side of the rectangular template 61.

Thereby, in a case where the in-image search means 23 searches the position of the characteristic section 3 automatically using the rectangular template 61, search required time is prominently reduced since the number of points of search for the amount of overlap is limited to four. In addition, in a case where the operator manually searches the position of the characteristic section 3 using the rectangular template 61, it is extremely easy to determine the degree of overlap. However, determination by the operator is necessary in a case where the characteristic section 3X in the captured image 4X changes shape and any of the feature points 31 to 34 in the captured image 4X disappear.

### (7. Board Position Search Device of Third Embodiment)

Next, concerning the board position search device of the third embodiment, the points that are different from the first and second embodiments will be mainly explained. In the third embodiment, the configuration of the board production line 9 and the component mounting machine 1 are the same in the first embodiment, and settings of multiple feature points of the characteristic section 3, and the shape of the template are different from the first and second embodiments. Fig. 8 is a diagram of the screen of the display section 96 that explains settings of feature points of a characteristic section 3 and a template shape in the third embodiment.

In the third embodiment, the multiple feature points of the characteristic section 3 are set as a total of five points. That is, a feature point 35 that is equivalent to the reference point that is set in the characteristic section 3, two feature points 36, 37 of a third set that interpose the feature point 35 and are disposed symmetrically in the X-axis direction (first direction) and two feature points 38, 39 of a fourth set that interpose the feature point 35 and are disposed symmetrically in the Y-axis direction (second direction) are set. In the present third embodiment, as a simple example, the feature points 36 to 39 are set the same as the feature points 31 to 34 of the second embodiment, and the center position in the X-axis direction and the Y-axis direction of the characteristic section 3 is set as the feature point 35 that is equivalent to the reference point. Not limited thereto, it is possible to freely set predetermined feature points that easily specify the position according to the shape of the characteristic section 3.

Meanwhile, the template is a largely variable rectangular template 65 in which a rectangular shape is simulated that is disposed parallel to the X-axis direction and the Y-axis direction. Each side of a variable rectangular template 65 is equivalent to simulation points that are to overlap with each of the four feature points 36 to 39. The variable rectangular template 65 indicates a center template 66 with a cross shape that represents a rectangular shape center position. Coordinate values C (x, y) in the captured image 4X of the center template 66 are displayed at all times at the top right of the screen.

Furthermore, the board position search device of the third embodiment is provided with the manual operation means 25 that is the same as the second embodiment. The operator selects an equivalent side by clicking the pointer of the mouse of the input section 95 to superimpose any side of the variable rectangular template 65, and subsequently, clicks the pointer to overlap with the movement cursors 251 to 254. Thereby, it is possible to modify the size of the variable rectangular template 65 by moving only the selected side.

In Fig. 8, the search result of the in-image search means 23 fails, and the variable rectangular template 65 is displayed at a position that is indicated by an initially broken line. The operator is able to select the left side of the variable rectangular template 65 and set the shape of the variable rectangular template 65 that is indicated by a solid line by using the right movement cursor 254. In the variable rectangular template 65 of the shape that is indicated by a solid line, each side overlaps with the respective feature points 36 to 39. Furthermore, the center template 66 automatically superimposes the feature point 35. At this time, the operator is able to calculate the position of the characteristic section 3 based on the coordinate values C (x, y) of the center template 66.

In the board position search device of the third embodiment, the multiple feature points of the characteristic section 3 have a total of five points of the feature point 35 that is equivalent to the reference point that is set in the characteristic section 3, two feature points 36, 37 of a third set that interpose the feature point 35 and are disposed symmetrically in the X-axis direction (first direction) and two feature points 38, 39 of a fourth set interpose the feature point 35 and are disposed symmetrically in the Y-axis direction (second direction), and the template is a largely variable rectangular template 65 in which a rectangular shape is simulated that is disposed parallel to the X-direction and the Y-axis direction, and the multiple simulation points of the template are each side and the center template 66 of the variable rectangular template 65.

Thereby, in the same manner as the second embodiment, in a case where the in-image search means 23 searches the position of the characteristic section 3 automatically using the variable rectangular template 65, search required time is prominently reduced since the number of points of search for the amount of overlap is limited to four. In addition, in a case where the operator manually searches the position of the characteristic section 3 using the variable rectangular template 65, it is extremely easy to determine the degree of overlap. However, determination by the operator is necessary in a case where the characteristic section 3X in the captured image 4X changes shape and any of the feature points 35 to 39 in the captured image 4X disappear.

### (8. Board Position Search Device 2D of Fourth Embodiment and Component Mounting Machine 1D of Embodiment)

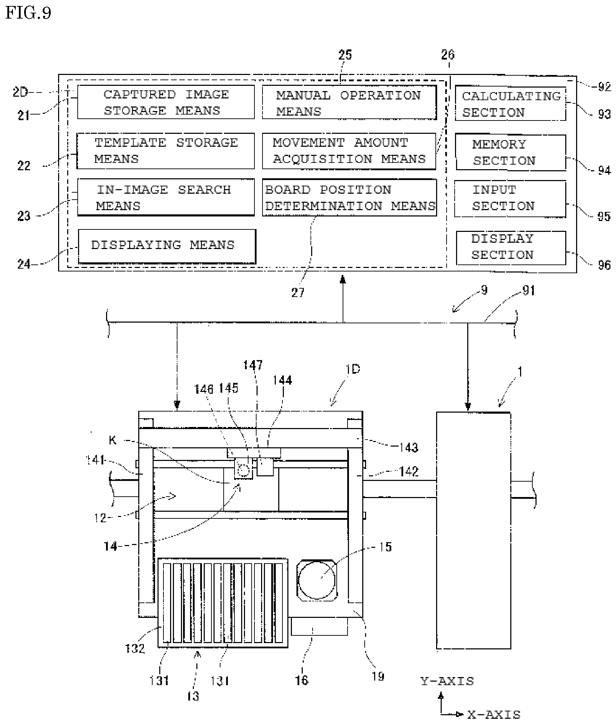

Next, concerning a board position search device 2D of the fourth embodiment and a component mounting machine 1D of the embodiment, the points that are different from the first to third embodiments will be mainly explained. Fig. 9 is a diagram that schematically indicates a configuration of the board position search device 2D of the fourth embodiment along with the board production line 9 and a component mounting machine 1D of the embodiment. The template that is used in the fourth embodiment may be any of the template 5 of the first embodiment, templates 5A, 5B that are alternative embodiments thereof, the rectangular template 61 of the second embodiment, and the variable rectangular template 65 of the third embodiment.

The board position search device 2D of the fourth embodiment is realized by software within the host computer 92. The board position search device 2D is further provided with the manual operation means 25, movement amount acquisition means 26, and board position determination means 27 in addition to the four means 21 to 24 that are explained in the first embodiment. The board position search device 2D is able to capture one functional section of the component mounting machine 1D of the embodiment.

The manual operation means 25 relatively moves the templates 5, 5A, 5B, 61, and 65 with respect to the characteristic section 3 in the captured image 4X according to the operation by the operator when the in-image search means 23 is not able to automatically search the position of the characteristic section 3X. The manual operation means 25 may be the four types of movement cursors 251 to 254 that are explained in the second and third embodiments, and may be a moving button of a keyboard of the input section 95 or another operation means of the operator. In addition, the manual operation means 25 may relatively move the captured images 4, 4X by fixing the position of the templates 5, 5A, 5B, 61, and 65 on the screen.

The movement amount acquisition means 26 acquires a relative movement amount of the templates 5, 5A, 5B, 61, and 65 when the operator determines that the multiple simulation points (other than the center points 52) of the templates 5, 5A, 5B, 61, and 65 most overlap with or most approach the multiple feature points in the captured images 4, 4X. In the second and third embodiments, the relative movement amount is able to be obtained from the amount of movement of the center templates 62, 66. In addition, also in the first embodiment and alternative embodiments thereof, the templates 5, 5A, 5B simply move in parallel, therefore acquisition of the relative movement amount is easy.

The board position determination means 27 determines the position of the board K based on the relative movement amount of the templates 5, 5A, 5B, 61, and 65 that is acquired by the movement amount acquisition means 26. Alternatively, the board position determination means 27 determines the position of the board K based on the search result when it is possible for the in-image search means 23 to automatically search the position of the characteristic section 3.

In the component mounting machine 1D of the embodiment, the hardware configuration is the same as the first embodiment, the board position search device 2D as one functional section is different from the first embodiment.

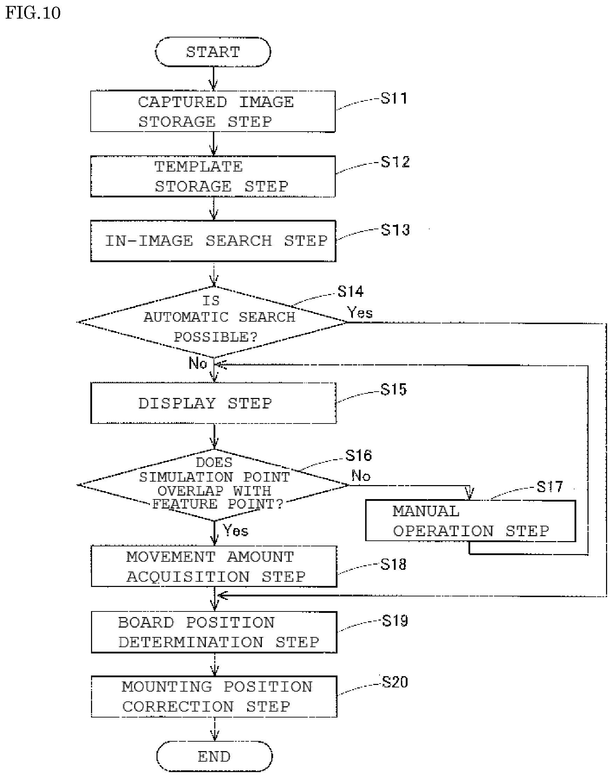

Fig. 10 is a diagram of an operation flow that represents an operation of the board position search device 2D of the fourth embodiment and the component mounting machine 1D of the embodiment. Concerning the characteristic section 3 at two locations on the board K, the board position search device 2D repeats a range from a captured image storage step S11 up to a movement amount acquisition step S18. The captured image storage step S11, a template storage step S12, and an in-image search step S13 in Fig. 10 are the same as step S1 to S3 of the first embodiment, therefore explanation is omitted. In step S14 after the in-image search step S13, the board position search device 2D determines whether or not it is possible for the in-image search means 23 to automatically search the position of the characteristic section 3. The board position search device 2D advances performance of control when it is possible to automatically search to a board position determination step S19, and advances execution of control when it is not possible to automatically search to a display step S15.

In the display step S15, the displaying means 24 operates to display such that it is possible to recognize the multiple simulation points (other than the center point 52) of the templates 5, 5A, 5B, 61, and 65, and displays such that the templates 5, 5A, 5B, 61, and 65 superimposes the captured images 4, 4X on the display section 96. In the subsequent step S16, the operator views the screen of the display section 96, and determines that the multiple simulation points of the templates 5, 5A, 5B, 61, and 65 are in a good state to most overlap with or in a good state to most approach the multiple feature points in the captured images 4, 4X. The operator inputs a good or bad determination result from the input section 95. The board position search device 2D advances performance of control when there is a good state to a movement amount acquisition step S18, and advances execution of control when there is no good state to a manual operation step S17.

In the manual operation step S17, the manual operation means 25 operates to receive the operation by the operator. The manual operation means 25 relatively moves the templates 5, 5A, 5B, 61, and 65 with respect to the characteristic section 3X in the captured image 4X according to an operation by the operator. Thereafter, the process returns to the display step S15, and the displaying means 24 updates display of the newest state after relative movement. Steps S15 to S17 are repeatedly performed by the operator in step S16 until the good state is determined.

In the movement amount acquisition step S18 after the good state is determined, the movement amount acquisition means 26 operates and acquires the relative movement amount of the templates 5, 5A, 5B, 61, and 65. In step S14 or the board position determination step S19 continuous to the movement amount acquisition step S18, the board position determination means 27 operates to determine the position of the board K. In other words, the board position determination means 27 obtains the position and rotation of board K based on a result of automatic search of the characteristic section 3 at two locations, or a result of manual search of the characteristic section 3 at two locations, or a result or automatic search and manual search in combination. The board position determination means 27 transmits information of the position of the determined board K to a control device 16 of the component mounting machine 1D.

A subsequent mounting position correction step S20 is an operation of the component mounting machine 1D of the embodiment. The control device 16 transmits the information of the position and rotation of the board K to the component transfer device 14. The component transfer device 14 corrects a component mounting position based on the information of the position and rotation of the board K. Thereby, it is possible for the component transfer device 14 to maintain high precision of the mounting position when the component that is supplied from the component supply device 13 is mounted on the held board K.

In the board position search device 2D of the fourth embodiment, the displaying means 24 operates when the in-image search means 23 is not able to automatically search the position of the characteristic section 3. Thereby, when automatic search is not possible, it is possible for the operator to recognize by automatically operating the displaying means 24, and when automatic search is possible, the displaying means that is not necessary is omitted. Accordingly, the board position search device 2D has a high operation efficiency and is easy to use.

Furthermore, the board position search device 2D of the fourth embodiment is further provided with the manual operation means 25 that relatively moves the templates 5, 5A, 5B, 61, and 65 with respect to the characteristic section 3X in the captured image 4X according to the operation by the operator when the in-image search means 23 is not able to automatically search the position of the characteristic section 3, the movement amount acquisition means 26 that acquires a relative movement amount of the template when the operator determines that the multiple simulation points of the templates 5, 5A, 5B, 61, and 65 most overlap with or most approach the multiple feature points in the captured image 4X, and the board position determination means 27 that determines the position of the board K based on the relative movement amount of the acquired templates 5, 5A, 5B, 61, and 65 or a search result when the in-image search means 23 is able to automatically search the position of the characteristic section 3.

Thereby, even if the characteristic section 3 that is substituted for the position fiducial mark on the board K has a predetermined shape, it is possible to determine the position of the board K by an automatic search by the in-image search means 23, or by a manual search that is realized by the displaying means 24, the manual operation means 25, and the like.

In addition, the component mounting machine 1D of the embodiment is provided with the board conveyance device 12 that carries in, holds, and carries out the board K, the board position search device 2D of the fourth embodiment that determines the position of the held board K, and a component transfer device 14 that corrects a mounting position of the component based on the position of the determined board K when the component that is supplied from the component supply device 13 is mounted on the held substrate K.

Thereby, production of the board K is continued while the position of the board K is determined by automatically searching using the in-image search means 23 of the board position search device 2D. Then, when it is not possible to automatically search using the in-image search means 23, the operator adjusts a situation in which the position of the board K is searched by a manual operation. Accordingly, production efficiency of the board K is comprehensively increased.

### (9. Applications and Modifications of Embodiment)

Note that, it is possible to adopt a predetermined shape other than the characteristic section 3 with the gourd shape indicated in Fig. 2 as the shape of the characteristic section which replaces the position fiducial mark on the board K. In addition, in a case where rotation of the board K is not considered, the characteristic section 3 may be set at one location of the board K. Furthermore, the board position search device 2D of the fourth embodiment is able to install a board production device other than the component mounting machines 1, 1D, for example, a solder printing machine or a board inspection machine. Various other applications and modifications of the present invention are possible.

### Reference Signs List

1, 1D: component mounting machine, 12: board conveyance device, 13: component supply device, 14: component transfer device, 147: board camera, 16: control device, 2, 2D: board position search device, 21: captured image storage means, 22: template storage means, 23: in-image search means, 24: displaying means, 25: manual operation means, 26: movement amount acquisition means, 27: board position determination means, 3, 3X: characteristic section, 31-39: feature point, 4, 4X: captured image, 5, 5A, 5B: template, 51: line segment template, 52: center point, 53: inside, 54: outside, 55: line segment template, 56: symbol, 57: tangent template, 61: rectangular template, 62: center template, 65: variable rectangular template, 66: center template, 9: board production line, 92: host computer

## Claims

1. A circuit board position search device (2) comprising:
captured image storage means (21) for storing a captured image for which a characteristic section (3, 3X) with a predetermined shape that is disposed on two predetermined positions on the circuit board is imaged;
template storage means (22) for storing a template (5) in which a plurality of simulation points are included that simulate a relative positional relationship of a plurality of feature points of the characteristic section (3, 3X);
in-image search means (23) for searching a position of the characteristic section (3, 3X) in the captured image, wherein the in-image search means (23) is configured to determine the position and an orientation of the circuit board based on a relative movement amount of the template (5) determined for superimposing the characteristic section (3, 3X) disposed on the two predetermined positions; and
displaying means (24) for displaying such that the plurality of simulation points of the template (5) are recognizable by an operator and displaying the template (5) superimposed on the captured image,
wherein the circuit board position search device (2) is configured to determine whether the in-image search means (23) is able to automatically search the position of the characteristic section (3),
wherein the displaying means (24) is configured to operate only when the circuit board position search device (2) determines that the in-image search means (23) is not able to automatically search the position of the characteristic section (3, 3X).

2. The circuit board position search device (2) according to Claim 1,
wherein the plurality of feature points (51) are discreetly positioned on an external line of the characteristic section (3, 3X).

3. The circuit board position search device (2) according to Claim 2,
wherein the template (5) is made of an aggregate of the line segment template (51) that simulates a line segment which intersects with the external line through each feature point of the characteristic section (3, 3X), and the plurality of simulation points of the template (5) are center points of each of the line segment templates.

4. The circuit board position search device (2) according to Claim 3,
wherein each of the line segment templates has a different display color on an inside and an outside of the external line at a boundary of the respective center points.

5. The circuit board position search device (2) according to Claim 3,
wherein each of the line segment templates has a symbol for displaying the respective center points.

6. The circuit board position search device (2) according to Claim 2,
wherein the template (5) is made of an aggregate of a tangent template that simulates a tangent that contacts the external line through each feature point of the characteristic section (3, 3X), and the plurality of simulation points of the template are contact points of each of the tangent templates.

7. The circuit board position search device (2) according to Claim 2,
wherein the template (5) is made of an aggregate of a symbol template that symbolizes each feature point of the characteristic section (3, 3X) as the respective simulation points.

8. The circuit board position search device (2) according to any one of claims 3 to 7,
wherein the displaying means is configured to change a display color of at least one of the line segment template, the tangent template, and the symbol template according to positional relationship of the feature points in the captured image in a case where the template (5) relatively moves with respect to the characteristic section (3, 3X) in the captured image.

9. The circuit board position search device (2) according to Claim 1,
wherein a plurality of feature points of the characteristic section (3, 3X) are a total of four points, consisting of two points of a first set that is most separated in a first direction out of the points on the external line of the characteristic section (3, 3X) and of two points of a second set that is most separated in a second direction that is orthogonal to the first direction, and
the template (5) is a rectangular template in which a rectangular shape is simulated that is disposed parallel to the first direction and the second direction through the two points of the first set and the two points of the second set, and the plurality of simulation points of the template (5) are each side of the rectangular template.

10. The circuit board position search device (2) according to Claim 1,
wherein a plurality of feature points of the characteristic section (3, 3X) are a total of five points, consisting of a reference point that is set in the characteristic section (3, 3X), two points of a third set that interpose the reference point and that are disposed symmetrically in the first direction, and two points of a fourth set that interpose the reference point and that are disposed symmetrically in the second direction that is orthogonal to the first direction, and
the template (5) is a largely variable rectangular template in which a rectangular shape is simulated that is disposed parallel to the first direction and the second direction, and the plurality of simulation points of the template (5) are each side and a center of the variable rectangular template.

11. The circuit board position search device (2) according to any one of claims 1 to 10, further comprising:
manual operation means for relatively moving the template (5) with respect to the characteristic section (3, 3X) in the captured image according to an operation by an operator when the in-image search means is not able to automatically search the position of the characteristic section (3, 3X);
movement amount acquisition means for acquiring a relative movement amount of the template (5) when the operator determines that the plurality of simulation points of the template (5) most overlap with or most approach the plurality of feature points in the captured image; and
circuit board position determination means for determining a position of the circuit board based on the relative movement amount of the acquired template or a search result when the in-image search means is able to automatically search the position of the characteristic section (3, 3X).

12. A component mounting machine (1) comprising:
a circuit board conveyance device (12) that is configured to carry in, hold, and carry out a circuit board;
the circuit board position search device (2) according to Claim 11 that is configured to determine the position of held board; and
a component transfer device (14) that is configured to correct a mounting position of the component based on the determined circuit board position when the component that is supplied from a component supply device (13) is mounted on the held substrate.

## Patentansprüche

1. Vorrichtung (2) zum Suchen einer Position einer Leiterplatte, die umfasst:
eine Einrichtung (21) für Speicherung eines aufgenommenen Bildes, die ein aufgenommenes Bild speichert, für das ein Bild eines charakteristischen Abschnitts (3, 3X) mit einer vorgegebenen Form erzeugt wird, der an zwei vorgegebenen Positionen auf der Leiterplatte angeordnet ist;
eine Einrichtung (22) für Speicherung eines Musters, die ein Muster (5), in dem eine Vielzahl von Simulations-Punkten enthalten ist, die eine relative Positionsbeziehung einer Vielzahl von Merkmals-Punkten des charakteristischen Abschnitts (3, 3X) simulieren;
eine Einrichtung (23) zum Suchen innerhalb eines Bildes, die eine Position des charakteristischen Abschnitts (3, 3X) in dem aufgenommenen Bild sucht, wobei die Einrichtung (23) zum Suchen innerhalb eines Bildes so ausgeführt ist, dass sie die Position und eine Ausrichtung der Leiterplatte auf Basis eines Betrages relativer Bewegung des Musters (5) bestimmt, der zum Überlagern des charakteristischen Abschnitts (3, 3X) bestimmt wird, der an den zwei vorgegebenen Positionen angeordnet ist; und
eine Anzeigeeinrichtung (24), die Anzeige so durchführt, dass die Vielzahl von Simulations-Punkten des Musters (5) von einer Bedienungsperson erkannt werden kann, und das Muster (5) das aufgenommene Bild überlagernd anzeigt,
wobei die Vorrichtung (2) zum Suchen einer Position einer Leiterplatte so ausgeführt ist, dass sie feststellt, ob die Einrichtung (23) zum Suchen innerhalb eines Bildes in der Lage ist, automatisch die Position des charakteristischen Abschnitts (3) zu suchen,
und die Anzeigeeinrichtung (24) so ausgeführt ist, dass sie nur dann arbeitet, wenn die Vorrichtung (2) zum Suchen einer Position einer Leiterplatte feststellt, dass die Einrichtung (23) zum Suchen innerhalb eines Bildes nicht in der Lage ist, die Position des charakteristischen Abschnitts (3, 3X) automatisch zu suchen.

2. Vorrichtung (2) zum Suchen einer Position einer Leiterplatte nach Anspruch 1,
wobei die Vielzahl von Merkmals-Punkten (51) einzeln auf einer Außenlinie des charakteristischen Abschnitts (3, 3X) positioniert sind.

3. Vorrichtung (2) zum Suchen einer Position einer Leiterplatte nach Anspruch 2,
wobei das Muster (5) aus einem Aggregat des Liniensegment-Musters (51) besteht, das ein Liniensegment simuliert, das sich mit der Außenlinie durch jeden Merkmals-Punkt des charakteristischen Abschnitts (3, 3X) schneidet, und die Vielzahl von Simulations-Punkten des Musters (5) Mittel-Punkte jedes der Liniensegment-Muster sind.

4. Vorrichtung (2) zum Suchen einer Position einer Leiterplatte nach Anspruch 3,
wobei jedes der Liniensegment-Muster eine unterschiedliche Anzeigefarbe an einer Innenseite und einer Außenseite der Außenlinie an einer Grenze der jeweiligen Mittel-Punkte aufweist.

5. Vorrichtung (2) zum Suchen einer Position einer Leiterplatte nach Anspruch 3,
wobei jedes der Liniensegment-Muster ein Symbol zum Anzeigen der jeweiligen Mittel-Punkte aufweist.

6. Vorrichtung (2) zum Suchen einer Position einer Leiterplatte nach Anspruch 2,
wobei das Muster (5) aus einem Aggregat eines Tangenten-Musters besteht, das eine Tangente simuliert, die mit der Außenlinie durch jeden Merkmals-Punkt des charakteristischen Abschnitts (3, 3X) in Kontakt ist, und die Vielzahl von Simulations-Punkten des Musters Kontakt-Punkte jeder der Tangenten-Muster sind.

7. Vorrichtung (2) zum Suchen einer Position einer Leiterplatte nach Anspruch 2,
wobei das Muster (5) aus einem Aggregat eines Symbol-Musters besteht, das jeden Merkmals-Punkt des charakteristischen Abschnitts (3, 3X) als die jeweiligen Simulations-Punkte symbolisiert.

8. Vorrichtung (2) zum Suchen einer Position einer Leiterplatte nach einem der Ansprüche 3 bis 7,
wobei die Anzeigeeinrichtung so ausgeführt ist, dass sie eine Anzeigefarbe des Liniensegment-Musters, des Tangenten-Musters oder/und des Symbol-Musters entsprechend der Positionsbeziehung der Merkmals-Punkte in dem aufgenommenen Bild in einem Fall ändert, in dem sich die Schablone (5) relativ in Bezug auf den charakteristischen Abschnitt (3, 3X) in dem aufgenommenen Bild bewegt.

9. Vorrichtung (2) zum Suchen einer Position einer Leiterplatte nach Anspruch 1,
wobei eine Vielzahl von Merkmals-Punkten des charakteristischen Abschnitts (3, 3X) insgesamt vier Punkte sind, die aus zwei Punkten einer ersten Gruppe, die von den Punkten auf der Außenlinie des charakteristischen Abschnitts (3, 3X) in einer ersten Richtung am weitesten getrennt ist,
sowie aus zwei Punkten einer zweiten Gruppe bestehen, die in einer zweiten Richtung, die orthogonal zu der ersten Richtung ist, am weitesten getrennt ist, und
das Muster (5) ein rechteckiges Muster ist, in dem eine rechteckige Form simuliert wird, die parallel zu der ersten Richtung und der zweiten Richtung durch die zwei Punkte der ersten Gruppe und die zwei Punkte der zweiten Gruppe angeordnet ist, und die Vielzahl von Simulations-Punkten des Musters (5) jede Seite des rechteckigen Musters sind.

10. Vorrichtung (2) zum Suchen einer Position einer Leiterplatte nach Anspruch 1,
wobei eine Vielzahl von Merkmals-Punkten des charakteristischen Abschnitts (3, 3X) insgesamt fünf Punkte sind, die aus einem Referenz-Punkt, der in dem charakteristischen Abschnitt (3, 3X) festgelegt ist, zwei Punkten einer dritten Gruppe, zwischen denen der Referenz-Punkt angeordnet ist und die symmetrisch in der ersten Richtung angeordnet sind, sowie zwei Punkten einer vierten Gruppe bestehen, zwischen denen der Referenz-Punkt angeordnet ist und die symmetrisch in der zweiten Richtung angeordnet sind, die orthogonal zu der ersten Richtung ist, und
das Muster (5) ein weitgehend variables rechteckiges Muster ist, in dem eine rechteckige Form simuliert wird, die parallel zu der ersten Richtung und der zweiten Richtung angeordnet ist, und die Vielzahl von Simulations-Punkten des Musters (5) jede Seite und eine Mitte des variablen rechteckigen Musters sind.

11. Vorrichtung (2) zum Suchen einer Position einer Leiterplatte nach einem der Ansprüche 1 bis 10, die des Weiteren umfasst:
eine Einrichtung für manuelle Betätigung zum relativen Bewegen des Musters (5) in Bezug auf den charakteristischen Abschnitt (3, 3X) in dem aufgenommenen Bild gemäß einer Betätigung durch eine Bedienungsperson, wenn die Einrichtung zum Suchen innerhalb eines Bildes nicht in der Lage ist, die Position des charakteristischen Abschnitts (3, 3X) automatisch zu suchen;
eine Einrichtung für Erfassung eines Bewegungs-Betrages, die einen Betrag relativer Bewegung des Musters (5) erfasst, wenn die Bedienungsperson feststellt, dass die Vielzahl von Simulations-Punkten des Musters (5) sich am meisten mit der Vielzahl von Merkmals-Punkten in dem aufgenommenen Bild überlappen oder sich diesen am meisten nähern; und
eine Einrichtung für Bestimmung einer Position einer Leiterplatte, die eine Position der Leiterplatte auf Basis des Betrages relativer Bewegung des erfassten Musters oder eines Suchergebnisses bestimmt, wenn die Einrichtung zum Suchen innerhalb eines Bildes in der Lage ist, die Position des charakteristischen Abschnitts (3, 3X) automatisch zu suchen.

12. Maschine (1) zum Montieren von Bauteilen, die umfasst:
eine Vorrichtung (12) für Förderung einer Leiterplatte, die so ausgeführt ist, dass sie eine Leiterplatte einführt, hält und ausführt;
die Vorrichtung (2) zum Suchen einer Position einer Leiterplatte nach Anspruch 11, die so ausgeführt ist, dass sie die Position der gehaltenen Platte bestimmt; und
eine Vorrichtung (14) für Überführung von Bauteilen, die so ausgeführt ist, dass sie eine Montageposition des Bauteils auf Basis der bestimmten Position der Leiterplatte korrigiert, wenn das Bauteil, das von einer Vorrichtung (13) für Zufuhr von Bauteilen zugeführt wird, auf dem gehaltenen Substrat montiert wird.

## Revendications

1. Dispositif de recherche de position de carte à circuit imprimé (2) comprenant :
un moyen de stockage d'image prise (21) destiné à stocker une image prise pour laquelle est mise en image une section caractéristique (3, 3X) présentant une forme prédéterminée qui est placée sur deux positions prédéterminées sur la carte à circuit imprimé,
un moyen de stockage de gabarit (22) destiné à stocker un gabarit (5) dans lequel sont inclus une pluralité de points de simulation qui simulent une relation de position relative d'une pluralité de points fonctionnels de la section caractéristique (3, 3X),
un moyen de recherche dans l'image (23) destiné à rechercher une position de la section caractéristique (3, 3X) dans l'image prise, le moyen de recherche dans l'image (23) étant configuré pour déterminer la position et l'orientation de la carte à circuit imprimé sur la base d'une valeur relative de mouvement du gabarit (5) déterminée pour la superposition de la section caractéristique (3, 3X) disposée sur les deux positions prédéterminées, et
un moyen d'affichage (24) destiné à réaliser un affichage de sorte à ce que la pluralité de points de simulation du gabarit (5) puissent être reconnus par un opérateur et à afficher le gabarit (5) superposé sur l'image prise,
où le dispositif de recherche de position de carte à circuit imprimé (2) est configuré pour déterminer si le moyen de recherche dans l'image (23) est capable de rechercher automatiquement la position de la section caractéristique (3),
où le moyen d'affichage (24) est configuré pour ne fonctionner que lorsque le dispositif de recherche de position de carte à circuit imprimé (2) a déterminé que le moyen de recherche dans l'image (23) n'est pas capable de rechercher automatiquement la position de la section caractéristique (3, 3X).

2. Dispositif de recherche de position de carte à circuit imprimé (2) selon la revendication 1,
dans lequel les différents points fonctionnels (51) sont positionnés de façon discrète sur une ligne externe de la section caractéristique (3, 3X).

3. Dispositif de recherche de position de carte à circuit imprimé (2) selon la revendication 2,
dans lequel le gabarit (5) est constitué d'un agrégat du gabarit de segment de ligne (51) qui simulent un segment de ligne qui coupe la ligne externe par chaque point fonctionnel de la section caractéristique (3, 3X), et les différents points de simulation du gabarit (5) sont des points centraux de chacun des gabarits de segments de ligne.

4. Dispositif de recherche de position de carte à circuit imprimé (2) selon la revendication 3,
dans lequel chacun des gabarits de segments de ligne présente une couleur d'affichage différente sur l'intérieur et l'extérieur de la ligne externe au niveau de la limite des points centraux respectifs.

5. Dispositif de recherche de position de carte à circuit imprimé (2) selon la revendication 3,
dans lequel chacun des gabarits de segments de ligne comporte un symbole destiné à afficher les points centraux respectifs.

6. Dispositif de recherche de position de carte à circuit imprimé (2) selon la revendication 2,
dans lequel le gabarit (5) est constitué d'un agrégat d'un gabarit de tangente qui simule une tangente qui entre en contact avec la ligne externe par chaque point fonctionnel de la section caractéristique (3, 3X), et les différents points de simulation du gabarit sont des points de contact de chacun des gabarits de tangentes.

7. Dispositif de recherche de position de carte à circuit imprimé (2) selon la revendication 2,
dans lequel le gabarit (5) est constitué d'un agrégat d'un gabarit de symbole qui symbolise chaque point fonctionnel de la section caractéristique (3, 3X) en tant que points respectifs de simulation.

8. Dispositif de recherche de position de carte à circuit imprimé (2) selon l'une quelconque des revendications 3 à 7,
dans lequel le moyen d'affichage est configuré pour modifier la couleur d'affichage d'au moins l'un du gabarit de segment de ligne, du gabarit de tangente et du gabarit de symbole en fonction de la relation de position des points fonctionnels dans l'image prise dans le cas où le gabarit (5) se déplace relativement par rapport à la section caractéristique (3, 3X) dans l'image prise.

9. Dispositif de recherche de position de carte à circuit imprimé (2) selon la revendication 1,
dans lequel les différents points fonctionnels de la section caractéristique (3, 3X) représentent un total de quatre points, constitué de deux points d'un premier ensemble qui sont les plus séparés dans une première direction parmi les points sur la ligne externe de la section caractéristique (3, 3X) et de deux points d'un deuxième ensemble qui sont les plus séparés dans une seconde direction qui est orthogonale à la première direction, et
le gabarit (5) est un gabarit rectangulaire dans lequel est simulée une forme rectangulaire qui est placée parallèlement à la première direction et à la seconde direction par les deux points du premier ensemble et les deux points du deuxième ensemble, et les différents points de simulation du gabarit (5) représentent chaque côté du gabarit rectangulaire.

10. Dispositif de recherche de position de carte à circuit imprimé (2) selon la revendication 1,
dans lequel les différents points fonctionnels de la section caractéristique (3, 3X) représentent un total de cinq points, constitué d'un point de référence qui est établi dans la section caractéristique (3, 3X), de deux points d'un troisième ensemble qui intercalent le point de référence et sont disposés symétriquement, et de deux points d'un quatrième ensemble qui intercalent le point de référence et sont disposées symétriquement dans la seconde direction qui est orthogonale à la première direction, et
le gabarit (5) est un gabarit rectangulaire fortement variable dans lequel est simulée une forme rectangulaire qui est placée parallèlement à la première direction et à la seconde direction, et les différents points de simulation du gabarit (5) représentent chaque côté et le centre du gabarit rectangulaire variable.

11. Dispositif de recherche de position de carte à circuit imprimé (2) selon l'une quelconque des revendications 1 à 10, comprenant en outre :
un moyen de manœuvre manuel destiné à déplacer relativement le gabarit (5) par rapport à la section caractéristique (3, 3X) dans l'image prise en fonction d'une manœuvre effectuée par un opérateur lorsque le moyen de recherche dans l'image n'est pas capable de rechercher automatiquement la position de la section caractéristique (3, 3X),
un moyen d'acquisition de valeur de mouvement destiné à acquérir la valeur relative de mouvement du gabarit (5) lorsque l'opérateur a déterminé que la pluralité de points de simulation du gabarit (5) chevauchent principalement où se rapprochent principalement de la pluralité de points fonctionnels dans l'image prise, et
un moyen de détermination de position de carte à circuit imprimé destiné à déterminer la position de la carte à circuit imprimé sur la base de la valeur relative de mouvement du gabarit acquis ou d'un résultat de recherche lorsque le moyen de recherche dans l'image est capable de rechercher automatiquement la position de la section caractéristique (3, 3X).

12. Machine de montage de composants (1) comprenant :
un dispositif de transport de carte à circuit imprimé (12) qui est configuré pour insérer, supporter et faire sortir une carte à circuit imprimé,
le dispositif de recherche de position de carte à circuit imprimé (2) conforme à la revendication 11 qui est configurée pour déterminer la position de la carte supportée, et
un dispositif de transfert de composant (14) qui est configuré pour corriger la position de montage du composant sur la base de la position déterminée de la carte à circuit imprimé lorsque le composant qui est délivré d'un dispositif de délivrance de composants (13) est monté sur le substrat supporté.
